# EUROPÄISCHE PATENTSCHRIFT

(11) **EP 0 868 778 B1**
(45) Veröffentlichungstag und Bekanntmachung des Hinweises auf die Patenterteilung: **25.08.1999**
(21) Anmeldenummer: 96946146.6
(22) Anmeldetag: 16.12.1996
(51) Int. Cl.: H03H 9/05, H03H 9/10

(54) **ELEKTRONISCHES BAUELEMENT, INSBESONDERE MIT AKUSTISCHEN OBERFLÄCHENWELLEN ARBEITENDES BAUELEMENT - OFW-BAUELEMENT**
ELECTRONIC COMPONENT, ESPECIALLY ONE OPERATING WITH ACOUSTIC SURFACE WAVES (SW COMPONENT)
COMPOSANT ELECTRONIQUE, NOTAMMENT COMPOSANT FONCTIONNANT A L'AIDE D'ONDES DE SURFACE ACOUSTIQUES (COMPOSANT A ONDES DE SURFACE)

(30) Priorität: 21.12.1995 DE 19548050
(43) Veröffentlichungstag der Anmeldung: 07.10.1998
(73) Patentinhaber: SIEMENS MATSUSHITA COMPONENTS GmbH & CO. KG, 81541 München (DE)
(72) Erfinder: PAHL, Wolfgang, D-80336 München (DE); STELZL, Alois, D-81549 München (DE); KRÜGER, Hans, D-81737 München (DE)
(74) Vertreter: Epping, Wilhelm, Dr.-Ing.
(86) Internationale Anmeldenummer: DE9602409
(87) Internationale Veröffentlichungsnummer: WO9723950

(56) Entgegenhaltungen:
- EP-A- 0 637 871
- US-A- 4 945 323

## Beschreibung

Die vorliegende Erfindung betrifft ein elektronisches Bauelement, insbesondere mit akustischen Oberflächenwellen arbeitendes Bauelement - OFW-Bauelement - nach dem Oberbegriff des Patentanspruchs 1.

Elektronische Bauelemente der gattungsgemäßen Art erweisen sich als vorteilhaft, da das Substrat des Bauelements, die Leiterplatte und der elektrisch leitende Strukturen umgebende, zwischen Substrat und Leiterplatte angeordnete Rahmen an sich bereits ein fertiges, oft als "Chip-size Package" bezeichnetes Gehäuse bilden. Unter "Leiterplatte" wird bei vorliegender Erfindung jeder Leiterbahnen tragende Träger sowohl auf Kunststoff als auch auf Keramikbasis verstanden. Ein Problem besteht dabei jedoch darin, daß elektrische Verbindungen zwischen auf sich gegenüber liegenden Seiten der Leiterplatte befindlichen Leiterbahnen durch die Leiterplatte hindurchgeführt werden müssen, wodurch Undichtigkeiten des durch die vorgenannten Komponenten gebildeten Gehäuses auftreten können. Ist ein solches Gehäuse nicht dicht abgeschlossen, so kann beispielsweise durch Eintreten von Wassserdampf die Bauelementefunktion beeinträchtigt oder sogar zerstört werden.

Den Versuch, ein derartiges Gehäuse luftdicht abzuschließen, zeigt beispielsweise die EP-A-0,637,871, bei der das mit seinen elektrisch leitenden Strukturen zur Leiterplatte gekehrte piezoelektrische Substrat und die Leiterplatte über im Substratrandbereich angeordnetes isolierendes Harz miteinander verbunden sind.

Eine Schirmung, bestehend aus einer Metallkappe mit Sitz auf metallischen Belägen der Leiterplatte, mit in die mehrschichtige Leiterplatte eingelassenen weiteren metallischen Belegungen und mit Masseanschlüssen, die versetzt durch die mehrschichtige Leiterplatte nach außen geführt sind, sorgt dabei für ein geschirmtes Bauelement mit ausgezeichneten Frequenzcharakteristiken.

Die elektrischen Anschlüsse bzw. Ein- und Ausgangsterminals der elektrisch aktiven Strukturen, d.h. z.B. der IDW-Strukturen, sind bei dieser bekannten Ausführung über senkrecht zur Leiterplattenebene gerichtete Durchkontaktierungen nach außen geführt.

Die vorliegende Erfindung beruht auf der Erkenntnis, daß vorstehende "luftdichte" Harz-Verbindung zwischen Substrat und Leiterplatte nicht den an derartige Bauelemente gestellten Anforderungen genügt. Sie hat sich daher die Aufgabe gestellt, auch die Durchkontaktierungen der elektrischen Anschlüsse - Pads - durch die Leiterplatte einwandfrei gasdicht zu gestalten und diese Durchkontaktierungen an jede gewünschte Stelle über dem Bauelement zu führen.

Diese Erfindung wird bei einem elektronischen Bauelement der eingangs genannten Art erfindungsgemäß durch die Merkmale des kennzeichnenden Teils des Patentanspruchs 1 gelöst.

Weiterbildungen der Erfindungen sind Gegenstand von Unteransprüchen.

Die Erfindung wird nachfolgend anhand von Ausführungsbeispielen gemäß den Figuren der Zeichnung näher erläutert. Es zeigt:
- Figur 1: eine Explosionsdarstellung eines erfindungsgemäß ausgebildeten OFW-Bauelementes;
- Figur 2: eine der Fig. 1 entsprechende Darstellung des zusammengefügten OFW-Bauelements.

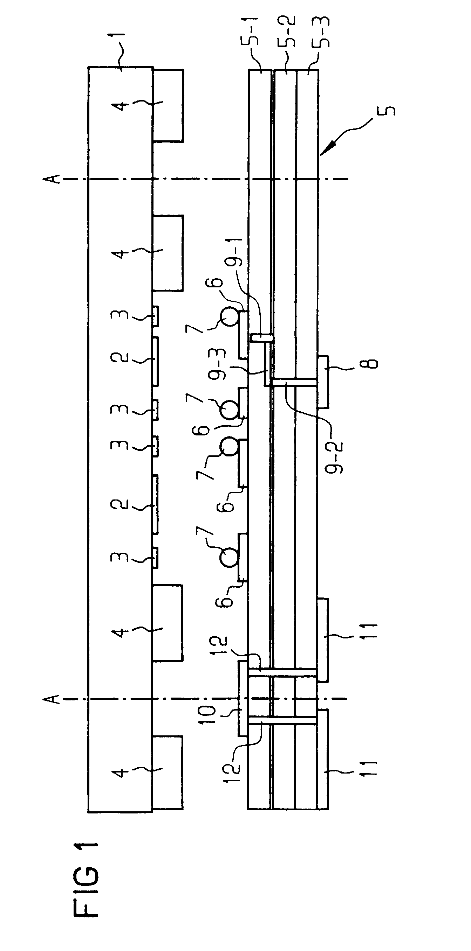

Gemäß dem oberen Teil von Fig. 1 wird ein OFW-Bauelementesystem durch ein piezoelektrisches Substrat 1 sowie auf diesen vorgesehenen leitenden Strukturen 2, Anschlußflächen 3 - Pads - sowie einem die leitenden Strukturen 2 und die Pads 3 umgebenden Rahmen 4 gebildet. Die elektrisch leitenden Strukturen 2 können beispielsweise Interdigitalwandler, Resonatoren oder Reflektoren bilden.

Um anzudeuten, daß eine große Anzahl von Bauelementesystemen der vorstehend erläuterten Art auf einem einzigen Substrat gleichzeitig hergestellt werden kann, ist in Fig. 1 das Substrat 1 nach links und rechts über senkrechte Linien A hinaus fortgesetzt, wobei auch Teile von Rahmen 4 dargestellt sind.

Weiterhin ist eine Leiterplatte 5 vorgesehen, auf deren dem Bauelementesystem zugekehrten Seite Leiterbahnen 6 und auf diesen Kontaktierungselemente 7 - bumps - vorgesehen sind.

Auch die Leiterplatte ist zur Andeutung der Realisierung einer Vielzahl von Bauelementen über die Linien A hinaus fortgesetzt.

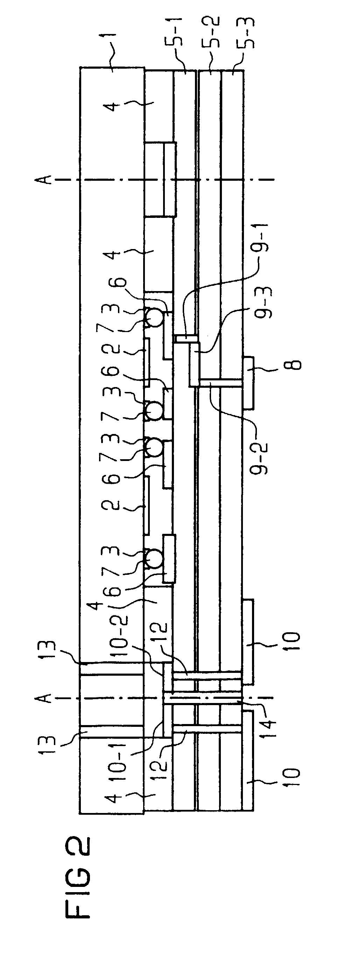

Werden Bauelementesystem und Leiterplatte gemäß Fig. 2 zusammengefügt, so sitzt der Rahmen 4 auf der Leiterplatte 5 auf, und es ergibt sich zwischen den Anschlußflächen 3 auf dem Substrat 1 sowie den Leiterbahnen 6 auf der Leiterplatte 5 und den auf den Leiterbahnen 6 befindlichen bumps 7 eine Flip-Chip-Montage.

Beim Einbau derartiger Bauelemente sind in aller Regel auch auf der dem Bauelementesystem abgekehrten Seite der Leiterplatte 5 Leiterbahnen vorgesehen, die mit den Leiterbahnen auf der dem Bauelementesystem zugekehrten Seite der Leiterplatte 5 elektrisch über Durchkontaktierungen miteinander verbunden werden müssen. Würde eine solche Durchkontaktierung geradlinig durch die Leiterplatte 5 geführt, so wäre das durch das Substrat 1, den Rahmen 4 und die Leiterplatte 5 gebildete Gehäuse nicht mehr gasdicht, so daß beispielsweise auch Wasserdampf in den Gehäuseinnenraum eintreten könnte, wodurch die Bauelementefunktion beeinträchtigt und sogar zerstört werden könnte. Um dies zu verhindern, ist erfindungsgemäß eine mehrteilige Durchkontaktierung vorgesehen, die in Richtung ihrer Erstreckung zwischen den Leiterbahnen 6, 8 auf der Leiterplatte 5 gegeneinander versetzte Teile 9 - 1 und 9 - 2 sowie ein diese Teile 9 - 1, 9 - 2 miteinander verbindendes und im rechten Winkel zu diesen ausgerichtetes Verbindungsstück 9 - 3 umfaßt. Auf diese Weise kann die Gasdichtigkeit des Gehäuses gewährleistet werden.

Die Leiterplatte 5 ist mehrschichtig ausgebildet, wobei mindestens zwei Schichten 5 - 1 und 5 - 2 vorgesehen sind, zwischen denen das Verbindungsstück 9 - 3 der Durchkontaktierung verläuft. Zweckmäßigerweise kann auch eine dritte Schicht 5 - 3 vorgesehen sein, bei der es sich beispielsweise um eine elektrische Abschirmung handelt. Weitere Schichten, insbesondere wenn das Basismaterial Kunststoff enthält, können auch so angeordnet sein, daß die Diffusionswege für Wasserdampf sich wesentlich verlängern.

Um die Gasdichtigkeit des Gehäuses zu unterstützen, sind mindestens die Schichten 5 - 1, 5 - 2 der Leiterplatte 5 aus Keramik hergestellt. Sind die Anforderungen an die Gasdichtigkeit des Gehäuses nicht so hoch, so können mindestens die Schichten 5 - 1, 5 - 2 der Leiterplatte 5 auch aus Kunststoff hergestellt sein.

Sind mindestens Teile der Leiterplatte 5 im vorgenannten Sinne aus Kunststoff hergestellt, so kann es sich beim Rahmen 4 auf dem Substrat 1 um einen Kleberahmen handeln. Sind mindestens Teile der Leiterplatte 5 aus Keramik hergestellt, so handelt es sich beim Rahmen 4 um einen Glaslot- oder Weichlotrahmen.

In bestimmten Fällen kann es auch zweckmäßig sein, auf der Leiterplatte 5 außerhalb eines Rahmens 4 des Bauelementesystems Leiterbahnen 10 vorzusehen und diese auf der davon abgewandten Seite der Leiterplatte 5 mit Leiterbahnen 11 zu verbinden. Da hier die Anforderungen an die Gasdichtigkeit nicht in dem Maße gegeben sind, wie es für das Bauelementesystem innerhalb des Rahmens 4 gilt, können die Leiterbahnen 10 und 11 über unversetzte Durchkontaktierungen 12 miteinander verbunden sein. Beim Durchtrennen zur Vereinzelung von Bauelementen längs der Linien A entstehen dann durch Trennschnitte 13, 14 Strukturen gemäß Fig. 2 mit Leiterbahnteilen 10 - 1, 10 - 2 auf der dem Substrat 1 zugekehrten Seite der Leiterplatte 5, so daß jeweils getrennte Kontaktierungsmöglichkeiten der vereinzelten Bauelemente außerhalb eines Rahmens 4 entstehen.

## Patentansprüche

1. Elektronisches Bauelement, insbesondere mit akustischen Oberflächenwellen arbeitendes Bauelement - OFW-Bauelement -, bei dem ein elektrisch leitende Strukturen (2, 3) auf einem piezoelektrischen Substrat (1) umfassendes Bauelementesystem (1 - 3) in Flip-Chip-Technik auf einer Leiterplatte (5) montiert ist, bei dem die elektrisch leitenden Strukturen (2, 3) innerhalb eines zwischen Substrat (1) und Leiterplatte (5) angeordneten Rahmens (4) liegen und ihre Anschlußflächen (3) - Pads - über Durchkontaktierungen in der Leiterplatte (5) mit Leiterbahnen (8) auf der vom Bauelementesystem (1 - 3) nach außen gekehrten Seite der Leiterplatte (5) verbunden sind,
**dadurch gekennzeichnet,**
daß die Leiterplatte (5) aus mindestens zwei Schichten (5 - 1, 5 - 2) gebildet ist und sämtliche Durchkontaktierungen (9 - 1, 9 - 2, 9 - 3) der Anschlußflächen (3) aus Teilstücken (9-1,9-2) und einem Verbindungsstück (9-3) gebildet sind, wobei die Teilstücke im rechten Winkel zu ihrer Erstreckung zwischen den Leiterbahnen zueinander versetzt sind und miteinander über das Verbindungsstück verbunden sind.

2. Bauelement nach Anspruch 1,
**dadurch gekennzeichnet,**
daß die Teilstücke der Durchkontaktierungen (9 - 1, 9 - 2), senkrecht zum Verbindungsstück (9 - 3) sind.

3. Bauelement nach Anspruch 1,
**dadurch gekennzeichnet,**
daß die Leiterplatte (5) eine Kunststoffplatte ist.

4. Bauelement nach Anspruch 1,
**dadurch gekennzeichnet,**
daß die Leiterplatte (5) eine Keramikplatte ist.

5. Bauelement nach Anspruch 1,
**dadurch gekennzeichnet,**
daß der Rahmen (4) aus einem Kleber gebildet ist.

6. Bauelement nach Anspruch 1,
**dadurch gekennzeichnet,**
daß der Rahmen (4) aus einem Lot gebildet ist.

7. Bauelement nach Anspruch 6,
**dadurch gekennzeichnet,**
daß das Lot des Rahmens (4) ein Glaslot ist.

8. Bauelement nach Anspruch 6,
**dadurch gekennzeichnet,**
daß das Lot des Rahmens (4) ein Weichlot ist.

9. Bauelement nach einem der Ansprüche 1 bis 8,
**dadurch gekennzeichnet,**
daß Leiterbahnen (10, 11) außerhalb des Rahmens (4) durch unversetzte Durchkontaktierungen (12) miteinander verbunden sind.

## Claims

1. Electronic component, in particular a component operating with surface acoustic waves - SAW component -, in which a component system (1-3) comprising electrically conductive structures (2, 3) on a piezoelectric substrate (1) is mounted using flip-chip technology on a printed circuit board (5), in which the electrically conductive structures (2-3) are located within a frame (4) which is arranged between the substrate (1) and the printed circuit board (5), and their connecting surfaces (3) - pads - are connected via through-plated holes in the printed circuit board (5) to conductor tracks (8) on the side of the printed circuit board (5) facing outwards from the component system (1-3), characterized in that the printed circuit board (5) is formed from at least two layers (5-1, 5-2) and all the through-plated holes (9-1, 9-2, 9-3) of the connecting surfaces (3) are formed from subelements (9-1, 9-2) and a connecting piece (9-3), the subelements being offset with respect to one another at right angles to their extent between the conductor tracks, and being connected to one another via the connecting piece.

2. Component according to Claim 1, characterized in that the subpieces of the through-plated holes (9-1, 9-2) are perpendicular to the connecting piece (9-3).

3. Component according to Claim 1, characterized in that the printed circuit board (5) is produced from a plastic plate.

4. Component according to Claim 1, characterized in that the printed circuit board (5) is a ceramic plate.

5. Component according to Claim 1, characterized in that the frame (4) is formed from an adhesive.

6. Component according to Claim 1, characterized in that the frame (4) is formed from a solder.

7. Component according to Claim 6, characterized in that the solder of the frame (4) is a glass solder.

8. Component according to Claim 6, characterized in that the solder of the frame (4) is a soft solder.

9. Component according to one of Claims 1 to 8, characterized in that conductor tracks (10, 11) outside the frame (4) are connected to one another by through-plated holes (12) which are not offset.

## Revendications

1. Composant électronique, en particulier composant fonctionnant avec des ondes de surface acoustiques - composant OFW - dans lequel un système de composants (1-3) comprenant des structures conductrices de l'électricité (2, 3) sur un substrat piézo-électrique (1) est monté sur une carte de circuit imprimé (5) dans une technique du type "flip-chip", dans lequel les structures conductrices de l'électricité (2, 3) se trouvent à l'intérieur d'un cadre (4) disposé entre le substrat (1) et la carte de circuit imprimé (5) et leur surfaces de connexion (3) - les pastilles - sont connectées par des métallisations traversantes formées dans la carte de circuit imprimé (5) à des pistes conductrices (8) prévues sur la face de la carte de circuit imprimé (5) dirigée vers l'extérieur par rapport au système de composants (1-3), caractérisé en ce que la carte de circuit imprimé (5) est formée d'au moins deux couches (5-1, 5-2) et toutes les métallisations traversantes (9-1, 9-2, 9-3) des surfaces de connexion (3) sont formées de segments partiels (9-1, 9-2) et d'un segment de liaison (9-3), les segments partiels étant décalés l'un par rapport à l'autre entre les pistes conductrices, à angle droit par rapport à leur extension, et étant connectés entre eux par le segment de liaison.

2. Composant selon la revendication 1, caractérisé en ce que les segments partiels des métallisations traversantes (9-1, 9-2) sont perpendiculaires au segment de liaison (9-3).

3. Composant selon la revendication 1, caractérisé en ce que la carte de circuit imprimé (5) est une plaque en matière plastique.

4. Composant selon la revendication 1, caractérisé en ce que la carte de circuit imprimé (5) est une plaque en céramique.

5. Composant selon la revendication 1, caractérisé en ce que le cadre (4) est formé d'une colle.

6. Composant selon la revendication 1, caractérisé en ce que le cadre (4) est formé d'une soudure.

7. Composant selon la revendication 6, caractérisé en ce que la soudure du cadre (4) est une soudure de verre.

8. Composant selon la revendication 6, caractérisé en ce que la soudure du cadre (4) est une soudure tendre.

9. Composant selon une des revendications 1 à 8, caractérisé en ce que les pistes conductrices (10, 11) sont connectées entre elles à l'extérieur du cadre (4) par des métallisations traversantes (12) sans décalage.
